# EUROPEAN PATENT APPLICATION

(11) **EP 4 704 543 A1**
(43) Date of publication of application: **04.03.2026**
(21) Application number: 25196480.5
(22) Date of filing: 18.08.2025
(51) Int. Cl.: H10W 70/40, H10W 74/10, H10D 80/00, H10W 40/00, H10B 80/00

(54) **SEMICONDUCTOR DEVICE WITH HYBRID MULTI-DIE PACKAGE AND METHOD THEREFOR**

(30) Priority: 28.08.2024 US 202418817395
(71) Applicant: NXP B.V., 5656 AG Eindhoven (NL)
(72) Inventor: Cheng, Hsin-En, 5656AG Eindhoven (NL); Sun, Yung-Ching, 5656AG Eindhoven (NL); Guo, Zhan-Ying, 5656AG Eindhoven (NL)
(74) Representative: Colaiuda, Antonella

(57) **Abstract**

A method of forming a semiconductor device includes forming a base leadframe having a plurality of leads and a die pad. A cavity is formed in each lead of a set of leads of the plurality of leads. Bond pads of a first semiconductor die are interconnected with respective leads of the plurality of leads. A metal core connector is placed on each cavity of the set of leads. A packaged device is mounted on the base leadframe by way of the metal core connectors. The packaged device includes a second semiconductor die mounted on package leads of a package leadframe. A first encapsulant encapsulates the second semiconductor die and package leadframe. A portion of each of the package leads is exposed through the first encapsulant. A second encapsulant encapsulates the first semiconductor die, a portion of the base leadframe, and a portion of the packaged device.

## Description

### Background

### Field

This disclosure relates generally to semiconductor device packaging, and more specifically, to semiconductor devices with a hybrid multi-die package and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified top-side-up plan view, an example packaged device at a stage of manufacture in accordance with an embodiment.
FIG. 2 through FIG. 4 illustrate, in simplified cross-sectional views, the example packaged device at stages of manufacture in accordance with an embodiment.
FIG. 5 illustrates, in a simplified top-side-up plan view, the example packaged device at a completed stage of manufacture in accordance with an embodiment.
FIG. 6 illustrates, in a simplified top-side-up plan view, an example semiconductor device with a hybrid multi-die package at a stage of manufacture in accordance with an embodiment.
FIG. 7 through FIG. 11 illustrate, in simplified cross-sectional views, the example semiconductor device at stages of manufacture in accordance with an embodiment.
FIG. 12 illustrates, in a simplified top-side-up plan view, the example semiconductor device with the hybrid multi-die package at a completed stage of manufacture in accordance with an embodiment.
FIG. 13 illustrates, in a simplified top-side-up cross-sectional view, the example semiconductor device with an external device mounted in a package-on-package configuration in accordance with an embodiment.

### Detailed Description

Generally, there is provided, a semiconductor device having a hybrid multi-die package. The semiconductor device includes a packaged device mounted on a base leadframe. The packaged device includes a first semiconductor die mounted on a package leadframe. The base leadframe includes a plurality of leads and a downset die pad. A second semiconductor die is mounted on the die pad of the base leadframe. A cavity is formed in each lead of the plurality of lead. The cavities are configured for holding spherical metal core connectors. The packaged device is mounted onto the base leadframe by way of the metal core connectors. The packaged device includes package leads of the package leadframe conductively connected to respective leads of the base leadframe. An encapsulant of the semiconductor device encapsulates the second semiconductor die mounted on the base leadframe and the packaged device. Portions of the package leads of the packaged device are exposed at a major side of the semiconductor device. The exposed leads of the packaged device at the major side of the semiconductor device are configured for attachment of an external component, for example. By forming the semiconductor device in a hybrid multi-die package in this manner, an efficient, cost effective package-on-package configuration may be realized.

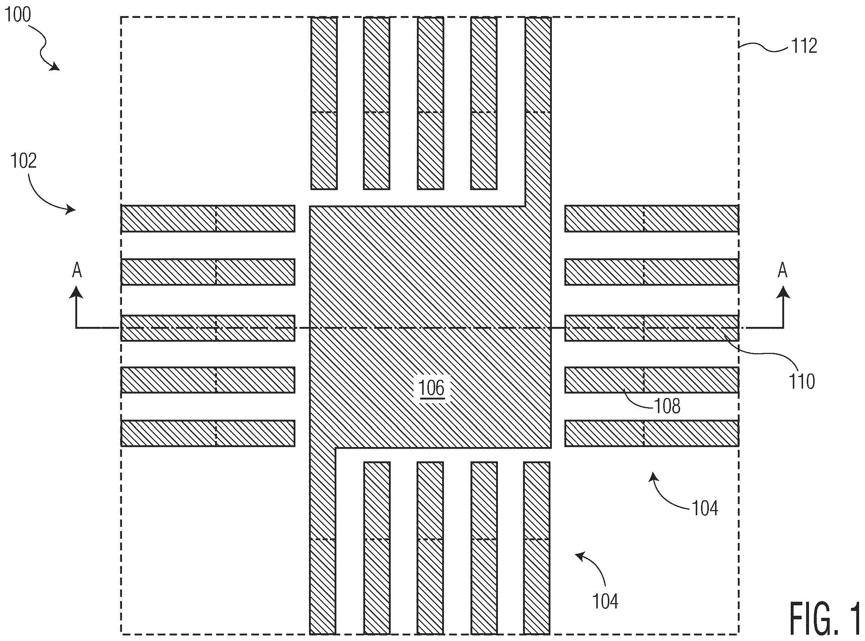

FIG. 1 illustrates, in a simplified top-side-up plan view, an example packaged device 100 at a stage of manufacture in accordance with an embodiment. At this stage, the packaged device 100 includes a package leadframe 102. The package leadframe 102 includes a plurality of package leads 104 surrounding a package flag 106. Each package lead 104 of the plurality of package leads includes a proximal portion 108 located near the package flag 106 and a distal portion 110 located near an outer perimeter 112 (shown as dashed outline for reference) of the encapsulant (formed at a subsequent stage) of the packaged device 100. In this embodiment, the proximal portion 108 of each package lead 104 has a reduced thickness (e.g., half-etched) while the distal portion 110 of each package lead 104 has a full thickness. For illustration purposes, a dashed line segment on each lead indicates an approximate dividing line between the proximal portions 108 and distal portions 110 of the package leads 104. Likewise, the package flag 106 is half-etched and has a reduced thickness substantially similar to the proximal portion 108 of each package lead 104. The term "half-etched," as used herein, refers to a method of selectively reducing the thickness of portions of the package leadframe by a predetermined amount. In this embodiment, the package flag 106 is directly connected to a set of package leads 104 as depicted in FIG. 1. The set of package leads 104 connected to the package flag 106 are configured to serve as support (during the manufacturing process) in addition to providing electrical connectivity, for example. In other embodiments, the package flag 106 may be supported by way of tie bars rather than package leads.

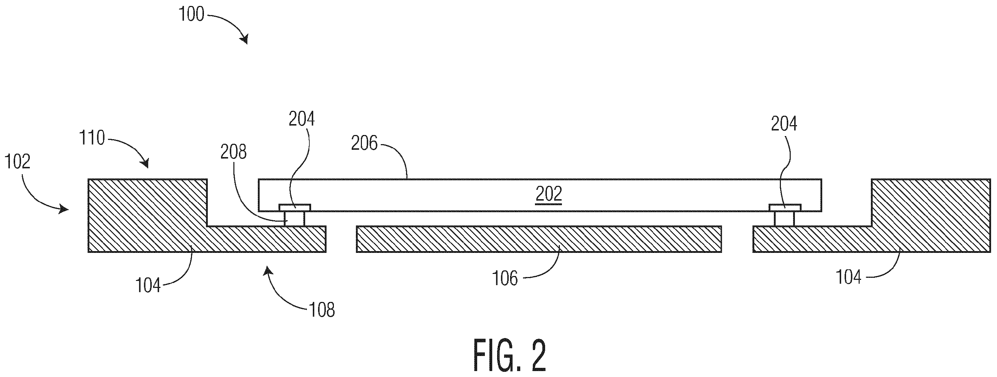

In this embodiment, the package leadframe 102, including the plurality of package leads 104 and package flag 106, is formed from a same contiguous metal sheet. The package leadframe 102 may be formed from a suitable conductive metal material, such as copper, silver, nickel, aluminum, or iron, or alloys thereof, for example. The conductive metal may be bare, partially plated, or plated with another metal or alloy such thereof. The term "conductive," as used herein, generally refers to electrical conductivity unless otherwise described. In this embodiment, the package leadframe 102 is configured for a quad flat no-lead (QFN) type package. The number and arrangement of the package leads 104 and package flag 106 in this embodiment are chosen for illustration purposes. Simplified cross-sectional views of the example semiconductor device 100 taken along line A-A at stages of manufacture are depicted in FIG. 2 through FIG. 4.

FIG. 2 illustrates, in a simplified top-side-up cross-sectional view, the example packaged device 100 at a subsequent stage of manufacture in accordance with an embodiment. At this stage, the packaged device 100 includes a semiconductor die 202 mounted on the package leadframe 102 and placed on a carrier substrate (not shown). The semiconductor die 202 is mounted within a recess formed by the reduced thickness proximal package lead portions 108 and package flag 106. In this embodiment, each bond pad 204 of the semiconductor die 202 is conductively connected to the proximal portion 108 of a respective lead 104 by way of a die connector 208. The die connectors 208 may be formed as stud bumps, copper pillars, solder balls, and the like, for example. The die connectors 208 may be formed from a suitable conductive material such as gold, copper, aluminum, solder, or alloys thereof.

The major side of the semiconductor die 202 having circuitry and bond pads 204 is characterized as the active side and the major side of the semiconductor die 202 opposite of the active side is characterized as the backside. In this embodiment, the semiconductor die 202 is in an active-side-down orientation having the backside 206 substantially coplanar with the top surface of the distal portions 110 of the package leads 104. The semiconductor die 202 may be formed from a suitable semiconductor material, such as silicon, germanium, gallium arsenide, gallium nitride, and the like. The semiconductor die 202 may include digital circuits, analog circuits, RF circuits, power circuits, memory, processor, the like, and/or combinations thereof formed at the active side, for example. The package flag 106 may be configured as a ground plane proximate to the active side of the semiconductor die 202 when connected to ground voltage supply, for example.

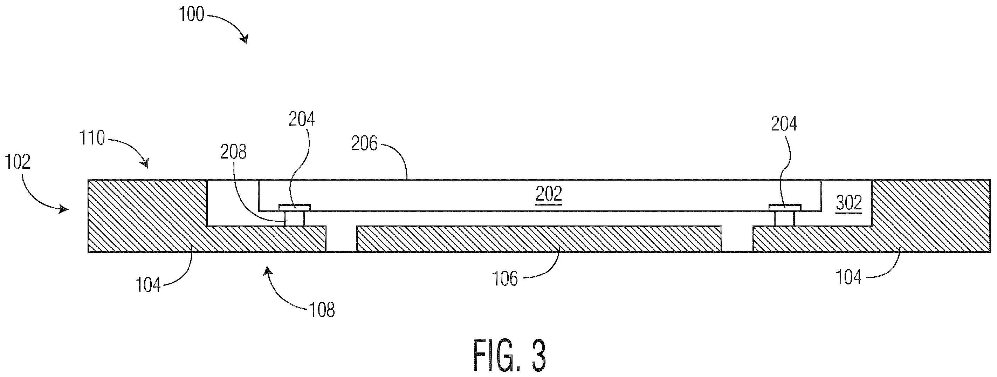

FIG. 3 illustrates, in a simplified top-side-up cross-sectional view, the example packaged device 100 at a subsequent stage of manufacture in accordance with an embodiment. At this stage, the packaged device 100 includes the semiconductor die 202 and the leadframe 102 at least partially encapsulated with an encapsulant 302 while temporarily affixed on the carrier substrate. In this embodiment, the semiconductor die 202 and the leadframe 102 may be encapsulated with the encapsulant 302 (e.g., epoxy molding compound) by way of a film-assisted molding (FAM) process. For example, a FAM tool using a conformal film may be engaged with the top surface of the distal portions 110 of the package leads 104 and the backside 206 of the semiconductor die 202 during the molding process to keep the top surface of the distal portions 110 and backside 206 free from encapsulant. Accordingly, the top surface of the distal portions 110 of the package leads 104 and the backside 206 of the semiconductor die 202 are exposed through the encapsulant 302 at the top major surface of the packaged device 100. In an alternative embodiment, the semiconductor die 202 and the leadframe 102 may be over-molded with the encapsulant 302 by way of an injection molding or transfer molding process, then subsequently subjecting the top surface of the encapsulant 302 to a grind process to expose the top surface of the distal portions 110 of the package leads 104 and the backside 206 of the semiconductor die 202 through the encapsulant, for example.

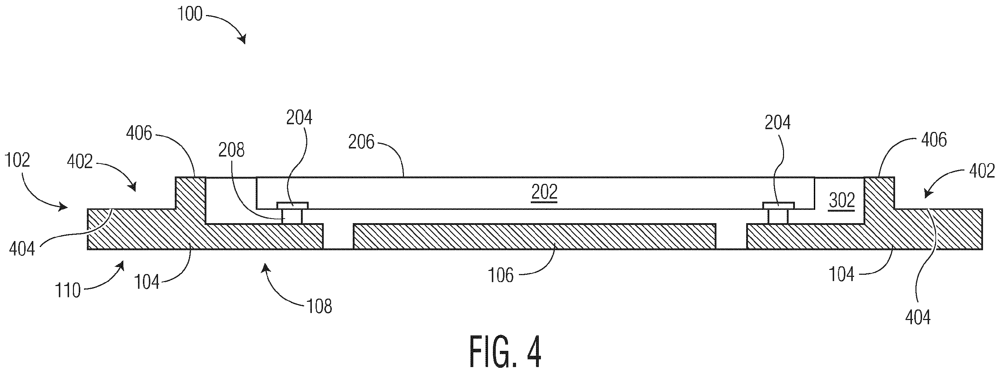

FIG. 4 illustrates, in a simplified top-side-up cross-sectional view, the example packaged device 100 at a subsequent stage of manufacture in accordance with an embodiment. At this stage, the packaged device 100 includes a recess 402 formed around an outer perimeter. After the semiconductor die 202 and the leadframe 102 are encapsulated with the encapsulant 302, the outer perimeter the packaged device 100 is subjected to a kerf cut along the top surface to form the recess 402. In this embodiment, the recess 402 is configured to reduce the thickness of the packaged device 100 along the outer perimeter to accommodate mounting to a leadframe at a subsequent stage of manufacture. In this embodiment, the distal portion 110 of each package lead 104 has a reduced thickness region 404 (by way of the kerf cut) and a remaining full thickness region 406. After forming the recess 402 and separating the packaged device 100 from the carrier substrate, the package leads 104 and package flag 106 are exposed through the encapsulant at the bottom major surface of the packaged device 100.

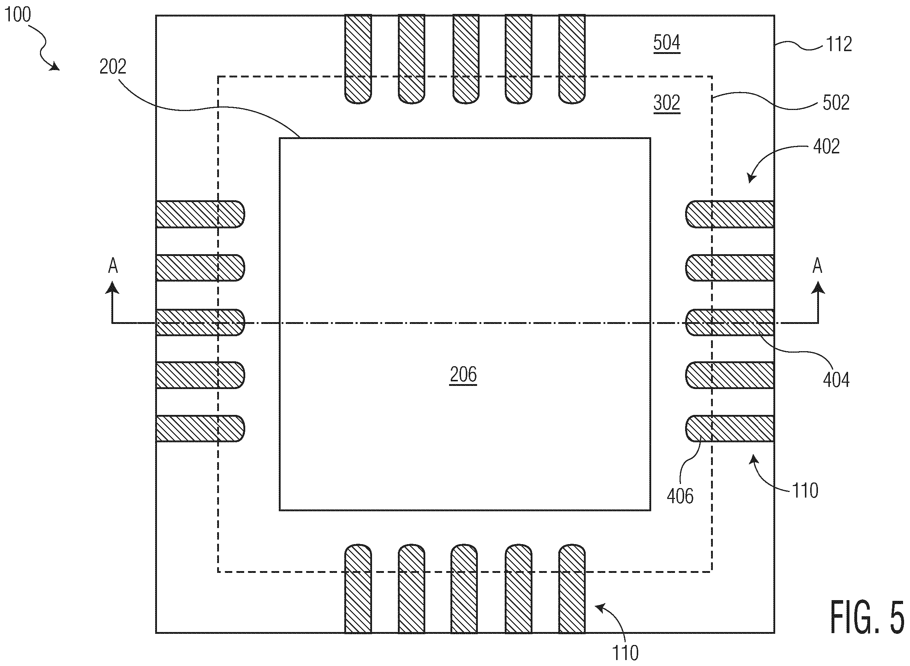

FIG. 5 illustrates, in a simplified top-side-up plan view, the example packaged device 100 at a completed stage of manufacture in accordance with an embodiment. At this stage, the packaged device 100 includes recess 402 formed around the outer perimeter of at the top major surface of the packaged device 100. In this embodiment, the backside 206 of the semiconductor die 202 and the distal portions 110 of the package leads of the package leadframe are exposed through the encapsulant 302 at the top major side of the packaged device 100. The exposed distal portion 110 of each package lead 104 include the reduced thickness region 404 in the recess 402 and full thickness region 406. The encapsulant 302 includes a reduced thickness region 504 in the recess 402. A dashed outline 502 indicates an approximate dividing line between the full thickness region of the packaged device 100 and the reduced thickness region of the recess 402, for example. In this embodiment, the reduced thickness region 404 of the exposed distal portion 110 of each package lead 104 is substantially coplanar with the surrounding reduced thickness region 504 of the encapsulant 302 in the recess 402 formed around the outer perimeter of the packaged device 100.

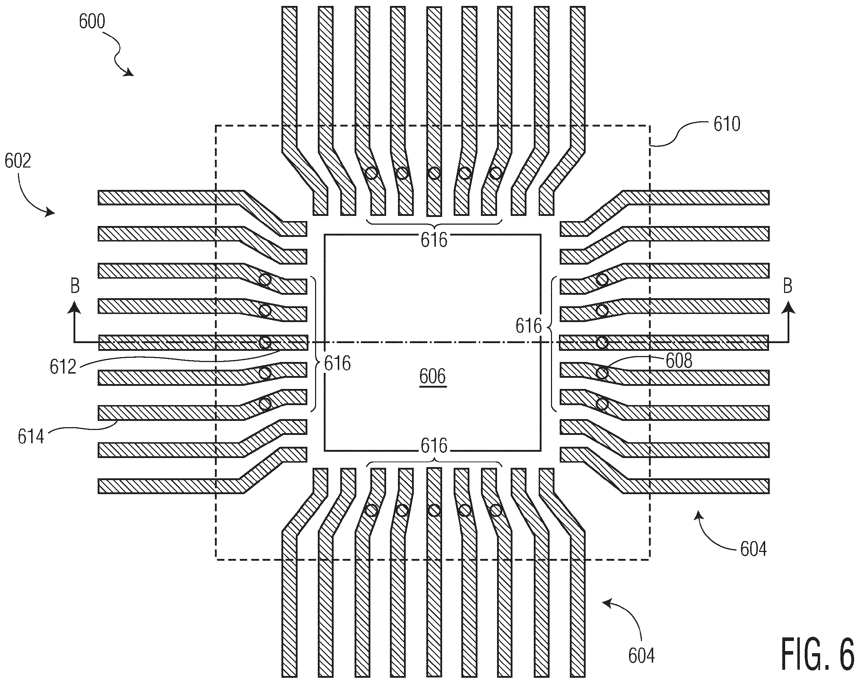

FIG. 6 illustrates, in a simplified top-side-up plan view, an example semiconductor device 600 with a hybrid multi-die package at a stage of manufacture in accordance with an embodiment. At this stage, the semiconductor device 600 includes a base leadframe 602. The base leadframe 602 includes a plurality of leads 604 surrounding a die pad 606. Each lead 604 of the plurality of leads includes a proximal portion 612 located between the die pad 606 and an outer perimeter 610 and a distal portion 614 located outside of the outer perimeter 610. The outer perimeter 610 (shown as dashed outline for reference) indicates an outer perimeter of an encapsulant (formed at a subsequent stage) of the semiconductor device 600, for example.

A cavity 608 is formed in the proximal portion 612 of each lead 604 of a set of leads 616 of the plurality of leads. The cavities 608 formed in the proximal portion of the leads may be formed by way of etching or stamping, for example. The cavities 608 are configured for holding metal core connectors when placed at a subsequent stage of manufacture, for example. In this embodiment, the set of leads 616 may be characterized as a subset of the plurality of leads 604. The die pad 606 is formed in a downset configuration in this embodiment. The die pad 606 is configured for attachment of a semiconductor die at a subsequent stage of manufacture, for example. Features of the base leadframe 602 such as tie bars (e.g., connected to die pad) and dam bars are not shown for illustration purposes.

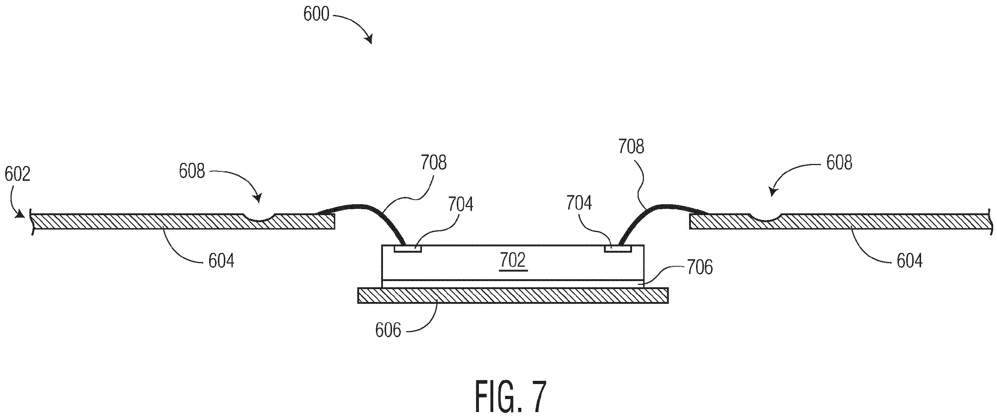

In this embodiment, the base leadframe 602, including the plurality of leads 604 and the die pad 606, is formed from a same contiguous metal sheet. The base leadframe 602 may be formed from a suitable conductive metal material, such as copper, silver, nickel, aluminum, or iron, or alloys thereof, for example. The base leadframe 602 may be bare, partially plated, or plated with another metal or alloy such thereof. In this embodiment, the base leadframe 602 is configured for a quad flat package (QFP) type package. The number and arrangement of the leads 604 and cavities 608 in this embodiment are chosen for illustration purposes. Simplified cross-sectional views of the example semiconductor device 600 taken along line B-B at stages of manufacture are depicted in FIG. 7 through FIG. 11.

FIG. 7 illustrates, in a simplified top-side-up cross-sectional view, the example semiconductor device 600 at a subsequent stage of manufacture in accordance with an embodiment. At this stage, the semiconductor device 600 includes a semiconductor die 702 mounted on the die pad 606 of the base leadframe 602. The semiconductor die 702 is mounted on the downset die pad 606 by way of a die attach material 706 such as a die attach film (DAF), for example. In this embodiment, each bond pad 704 of the semiconductor die 702 is conductively connected to the proximal portion of a respective lead 604 by way of a bond wire 708. The bond wires 708 may be formed from a suitable metal material such as copper, silver, gold, or alloys thereof, for example. The cavities 608 are formed in the proximal portion of each lead 604 of a set of leads 616 (FIG. 6).

The major side of the semiconductor die 702 having circuitry and bond pads 704 is characterized as the active side and the major side of the semiconductor die 702 opposite of the active side is characterized as the backside. In this embodiment, the semiconductor die 702 is in an active-side-up orientation having the backside of the semiconductor die 702 affixed to the die pad 606 of the base leadframe 602. The semiconductor die 702 may be formed from a suitable semiconductor material, such as silicon, germanium, gallium arsenide, gallium nitride, and the like. The semiconductor die 702 may include digital circuits, analog circuits, RF circuits, power circuits, memory, processor, the like, and/or combinations thereof formed at the active side, for example.

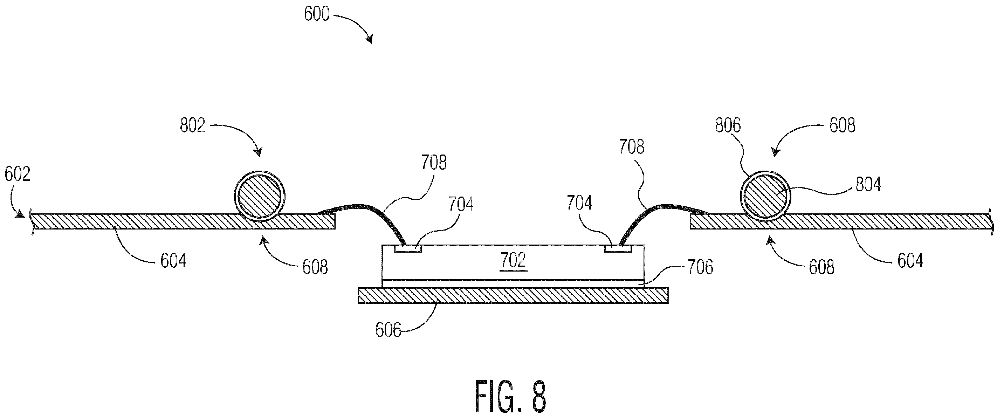

FIG. 8 illustrates, in a simplified top-side-up cross-sectional view, the example semiconductor device 600 at a subsequent stage of manufacture in accordance with an embodiment. At this stage, the semiconductor device 600 includes metal core connectors 802 placed and affixed in respective cavities 608. In this embodiment, the metal core connectors 802 include a substantially rigid spherical metal core 804 (e.g., copper) surrounded by a solder material 806. The solder material 806 may be formed as a thin coating or shell surrounding the metal core 804. The metal core connectors 802 are configured to serve as a substantially fixed height standoff (e.g., as determined by the rigid metal core) when a device is mounted on the base leadframe 602 by way of the metal core connectors at a subsequent stage of manufacture, for example.

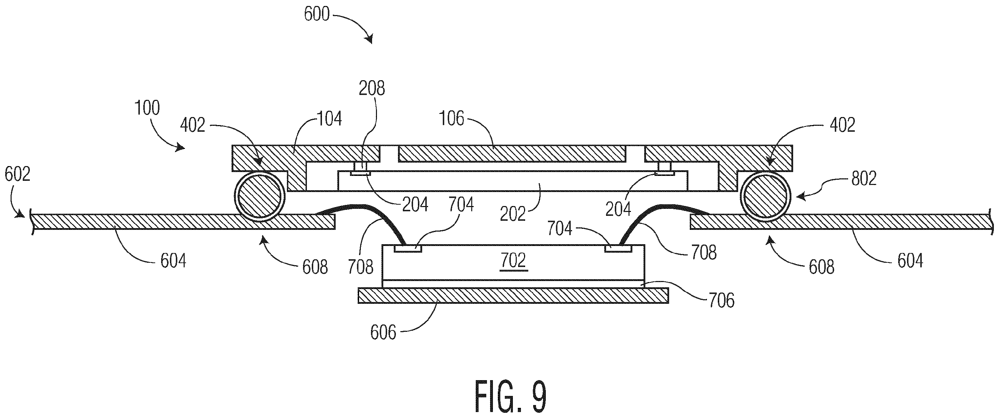

FIG. 9 illustrates, in a simplified top-side-up cross-sectional view, the example semiconductor device 600 at a subsequent stage of manufacture in accordance with an embodiment. At this stage, the semiconductor device 600 includes the packaged device 100 mounted onto the base leadframe 602. In this embodiment, the packaged device 100 is reoriented (e.g., flipped) such that exposed portions of leads 104 in the recess 402 at the top major side are placed onto the metal core connectors 802 of base leadframe 602 and subjected to a reflow process. After the solder material 802 of the metal core connectors 802 is reflowed, package leads 104 of the packaged device 100 are conductively interconnected with respective leads 604. In this embodiment, the semiconductor die 202 of the packaged device 100 is interconnected with the semiconductor die 702 by way of the metal core connectors 802. The metal core connectors 802 serve as a substantially fixed height standoff when the packaged device 100 is mounted onto the base leadframe 602 thus allowing ample room for the bond wires 708 which interconnect the semiconductor die 702 with the leads 604.

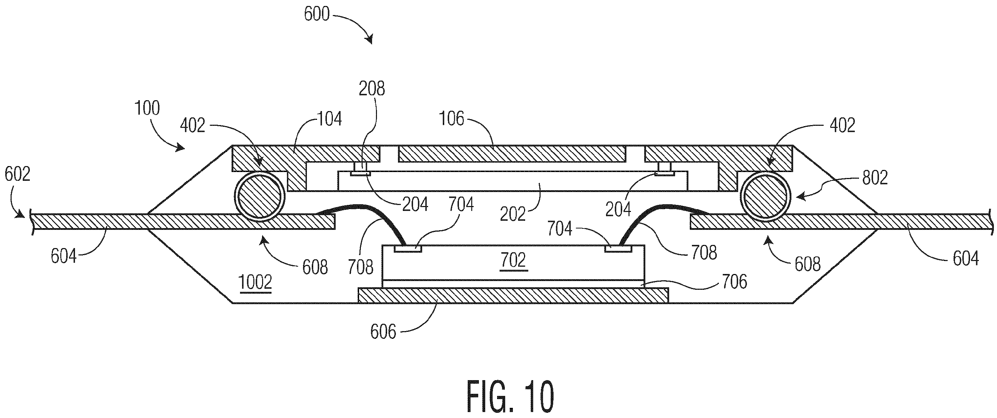

FIG. 10 illustrates, in a simplified top-side-up cross-sectional view, the example semiconductor device 600 at a subsequent stage of manufacture in accordance with an embodiment. At this stage, the semiconductor device 600 includes an encapsulant 1002 encapsulating the semiconductor die 702, a portion of the base leadframe 602, and a portion of the packaged device 100. In this embodiment, the semiconductor die 702, the base leadframe 602, and the packaged device 100 may be encapsulated with the encapsulant 1002 (e.g., epoxy molding compound) by way of a molding process such as injection molding, transfer molding, or FAM processes. In this embodiment, the bottom major side of the packaged device 100 is exposed through a top side of the encapsulant 1002. Likewise, the bottom surface of the die pad 606 is exposed through a bottom side of the encapsulant 1002. The distal portions of leads 604 extend laterally outside of the encapsulant 1002.

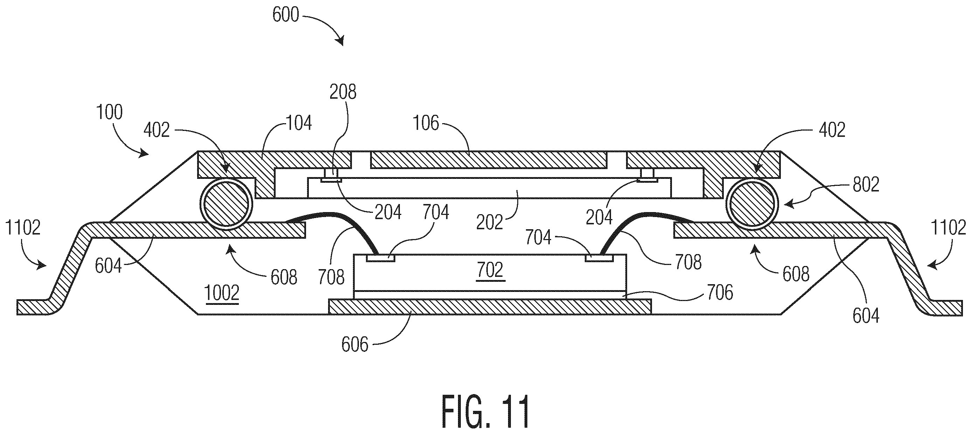

FIG. 11 illustrates, in a simplified top-side-up cross-sectional view, the example semiconductor device 600 at a subsequent stage of manufacture in accordance with an embodiment. At this stage, the semiconductor device 600 includes shaped leads 1102 formed from distal portions of leads 604. In this embodiment, the encapsulated semiconductor device 600 is subjected to a trim and form process. During the trim and form process, the distal portions of leads 604 (outside of the encapsulant 1002) are mechanically shaped. In this embodiment, the shaped leads 1102 are configured in a gullwing shape. In other embodiments, the distal portions of leads 604 may be mechanically formed in other suitable shapes (e.g., J-lead). The flat end regions of the shaped leads 1102 along with the exposed portion of the die pad 606 are configured for solder attachment to a printed circuit board, for example.

In this embodiment, portions of the package leads 104 and package flag 106 of the packaged device 100 are exposed through the top side of the semiconductor device 600. In this embodiment, the exposed portions of the package leads 104 and package flag 106 are configured for package-on-package (PoP) connection of one or more external components such as semiconductor die, sensors, active elements, passive elements, antennas, heat sinks, connectors, the like, and combinations thereof.

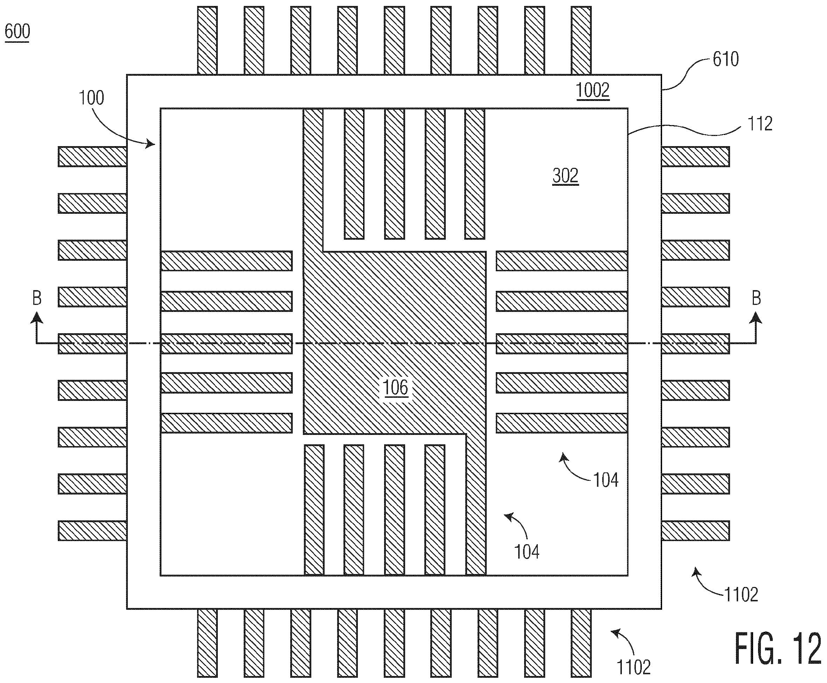

FIG. 12 illustrates, in a simplified top-side-up plan view, the example semiconductor device 600 with the hybrid multi-die package at a completed stage of manufacture in accordance with an embodiment. At this stage, the semiconductor device 600 is encapsulated with the encapsulant 1002 and has shaped leads 1102 (as depicted in FIG. 11). In this embodiment, the bottom major side of the packaged device 100 is exposed at the top side of the semiconductor device 600. the encapsulant 1002. A portion of the encapsulant 1002 surrounds the outer perimeter 112 of the packaged device 100 and extends to the outer perimeter 610 of the encapsulant 1002. The shaped leads 1102 extend outward from the encapsulant 1002 and are distributed around the outer perimeter 610.

In this embodiment, portions of the package leads 104 and package flag 106 of the packaged device 100 are exposed through the encapsulant 302 of the packaged device 100 at the top side of the semiconductor device 600. The exposed portions of the package leads 104 and package flag 106 provide conductive through package connectivity with the shaped leads 1102 by way of the metal core connectors 802 (as depicted in FIG. 11). In this embodiment, the exposed portions of the package leads 104 and package flag 106 are configured for connection of one or more external components such as semiconductor die, sensors, active elements (e.g., transistor, diode), passive elements (e.g., resistor, capacitor, inductor), connectors (single, multiple, coaxial), antennas, heat sinks, the like, and combinations thereof. The exposed portions of the package leads 104 and package flag 106 may be bare or otherwise plated to facilitate connection of the external component(s).

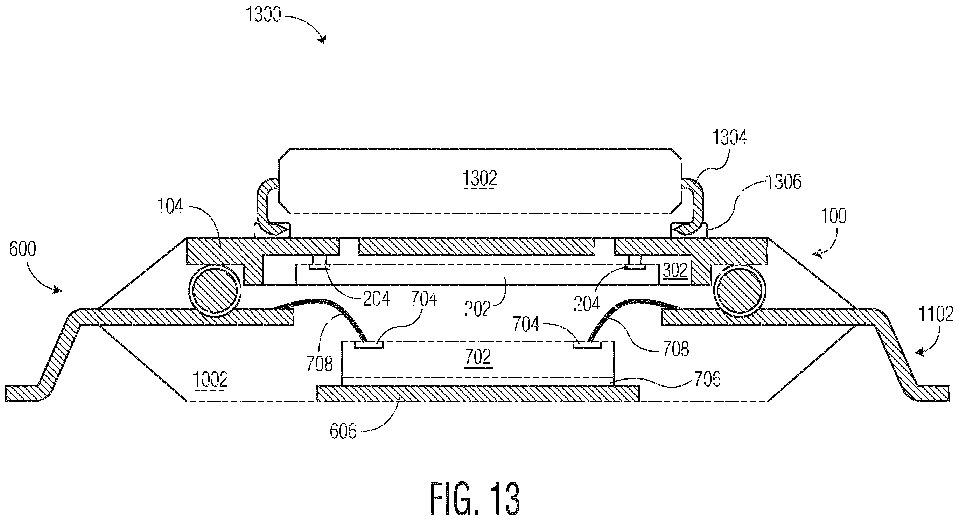

FIG. 13 illustrates, in a simplified top-side-up cross-sectional view, an example semiconductor device 1300 with an external component mounted in a PoP configuration in accordance with an embodiment. In this embodiment, the semiconductor device 1300 includes the semiconductor device 600 of FIG. 11 plus an externally mounted component 1302. In this embodiment, leads 1304 of the external component 1302 are conductively connected to the exposed portions of the package leads 104 by way of a conductive interface material 1306 (e.g., solder, solder paste, conductive adhesive). The external component 1302 as depicted in FIG. 13 is chosen for illustration purposes. The external component 1302 may be any of a semiconductor die, a sensor, an active element, a passive element, and the like, for example. The external component 1302 may be in the form of a bare semiconductor die, a leaded packaged device, a leadless packaged device, a surface mounted device, or the like, for example. By forming the stacked die arrangement of the semiconductor device 600 with exposed portions of the package leads 104 providing conductive through package connectivity with the leads 1102 by way of the metal core connectors 802, the external component 1302 may be interconnected with the semiconductor die 202 and 702 in the PoP arrangement without increasing the overall footprint of the semiconductor device 1300.

Generally, there is provided, a method of manufacturing a semiconductor device including: forming a base leadframe having a plurality of leads and a die pad, a cavity formed in each lead of a set of leads of the plurality of leads; affixing a first semiconductor die on the die pad of the base leadframe; interconnecting bond pads of the first semiconductor die with respective leads of the plurality of leads; placing a metal core connector on each cavity of the set of leads; mounting a packaged device on the base leadframe by way of the metal core connectors, the packaged device including: a second semiconductor die, a package leadframe having a plurality of package leads, the second semiconductor die mounted on the package leads of the package leadframe, and a first encapsulant encapsulating the second semiconductor die and package leadframe, a portion of each of the package leads exposed through the first encapsulant; and encapsulating with a second encapsulant the first semiconductor die, a portion of the base leadframe, and a portion of the packaged device. Bond pads of the first semiconductor die may be interconnected with the respective leads of the plurality of leads by way of bond wires. After encapsulating with the second encapsulant, the exposed portion of each of the package leads of the packaged device may remain exposed at a first major side. After encapsulating with the second encapsulant, a portion of the die pad of the base leadframe may be exposed at a second major side, the second major side opposite of the first major side. Bond pads of the second semiconductor die may be interconnected with the package leads of the package leadframe by way of die connectors. The die connectors are formed as copper pillars, stud bumps, or solder balls. Each of the metal core connectors may include a solid copper core surrounded by a solder material. The packaged device may further include a kerf cut along an outer perimeter portion, a distal portion of the package leads recessed along the outer perimeter by way of the kerf cut. The exposed portions of the package leads may be interconnected with respective leads of the set of leads by way of the metal core connectors.

In another embodiment, there is provided, a semiconductor device including a base leadframe having a plurality of leads and a die pad, a cavity formed in each lead of a set of leads of the plurality of leads; a first semiconductor die mounted on the die pad of the base leadframe, bond pads of the first semiconductor die interconnected with respective leads of the plurality of leads; a metal core connector affixed on each cavity of the set of leads; a packaged device mounted on the base leadframe by way of the metal core connectors, the packaged device including: a second semiconductor die, a package leadframe having a plurality of package leads, the second semiconductor die mounted on the package leads of the package leadframe, and a first encapsulant encapsulating the second semiconductor die and package leadframe, a portion of each of the package leads exposed through the first encapsulant at a bottom major side of the packaged device; and a second encapsulant encapsulating the first semiconductor die, a portion of the base leadframe, and a portion of the packaged device. The bond pads of the first semiconductor die may be interconnected with the respective leads of the plurality of leads by way of bond wires. The bottom major side of the packaged device may be exposed at a top major side of the semiconductor device. The exposed portion of each of the package leads may be configured for attachment of an external device. The exposed portions of the package leads may be interconnected with respective leads of the set of leads by way of the metal core connectors. Each of the metal core connectors may include a solid copper core surrounded by a solder material.

In yet another embodiment, there is provided, a method of manufacturing a semiconductor device including: forming a base leadframe having a plurality of leads and a die pad, a cavity formed in each lead of a set of leads of the plurality of leads; affixing a first semiconductor die on the die pad of the base leadframe, the first semiconductor die including a plurality of bond pads; interconnecting the plurality of bond pads of the first semiconductor die with respective leads of the plurality of leads; placing a metal core connector on each cavity of the set of leads; mounting a first major side of a packaged device on the base leadframe by way of the metal core connectors, the packaged device including: a second semiconductor die, a package leadframe having a plurality of package leads, bond pads at the active side of the second semiconductor die mounted on the package leads of the package leadframe by way of die connectors, and a first encapsulant encapsulating the second semiconductor die and package leadframe, a portion of each of the package leads exposed through the first encapsulant at a second major side of the packaged device opposite the first major side; and encapsulating with a second encapsulant the first semiconductor die, a portion of the base leadframe, and a portion of the packaged device. After encapsulating with the second encapsulant, the second major side of the packaged device may be exposed. The plurality of bond pads of the first semiconductor die may be interconnected with the respective leads of the plurality of leads by way of bond wires. Each of the metal core connectors may include a solid copper core surrounded by a solder material. The exposed portions of the package leads at the second major side of the packaged device may be configured for attachment of an external device.

By now, it should be appreciated that there has been provided a semiconductor device having a hybrid multi-die package. The semiconductor device includes a packaged device mounted on a base leadframe. The packaged device includes a first semiconductor die mounted on a package leadframe. The base leadframe includes a plurality of leads and a downset die pad. A second semiconductor die is mounted on the die pad of the base leadframe. A cavity is formed in each lead of the plurality of lead. The cavities are configured for holding spherical metal core connectors. The packaged device is mounted onto the base leadframe by way of the metal core connectors. The packaged device includes package leads of the package leadframe conductively connected to respective leads of the base leadframe. An encapsulant of the semiconductor device encapsulates the second semiconductor die mounted on the base leadframe and the packaged device. Portions of the package leads of the packaged device are exposed at a major side of the semiconductor device. The exposed leads of the packaged device at the major side of the semiconductor device are configured for attachment of an external component, for example. By forming the semiconductor device in a hybrid multi-die package in this manner, an efficient, cost effective package-on-package configuration may be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method of manufacturing a semiconductor device, the method comprising:
forming a base leadframe having a plurality of leads and a die pad, a cavity formed in each lead of a set of leads of the plurality of leads;
affixing a first semiconductor die on the die pad of the base leadframe;
interconnecting bond pads of the first semiconductor die with respective leads of the plurality of leads;
placing a metal core connector on each cavity of the set of leads;
mounting a packaged device on the base leadframe by way of the metal core connectors, the packaged device including:
a second semiconductor die,
a package leadframe having a plurality of package leads, the second semiconductor die mounted on the package leads of the package leadframe, and
a first encapsulant encapsulating the second semiconductor die and package leadframe, a portion of each of the package leads exposed through the first encapsulant; and
encapsulating with a second encapsulant the first semiconductor die, a portion of the base leadframe, and a portion of the packaged device.

2. The method of claim 1, wherein bond pads of the first semiconductor die are interconnected with the respective leads of the plurality of leads by way of bond wires.

3. The method of claim 1 or claim 2, wherein after encapsulating with the second encapsulant, the exposed portion of each of the package leads of the packaged device remains exposed at a first major side.

4. The method of claim 3, wherein after encapsulating with the second encapsulant, a portion of the die pad of the base leadframe is exposed at a second major side, the second major side opposite of the first major side.

5. The method of any preceding claims, wherein bond pads of the second semiconductor die are interconnected with the package leads of the package leadframe by way of die connectors.

6. The method of claim 5, wherein the die connectors are formed as copper pillars, stud bumps, or solder balls.

7. The method of any preceding claims, wherein each of the metal core connectors includes a solid copper core surrounded by a solder material.

8. The method of any preceding claims, wherein the packaged device further includes a kerf cut along an outer perimeter portion, a distal portion of the package leads recessed along the outer perimeter by way of the kerf cut.

9. The method of any preceding claims, wherein the exposed portions of the package leads are interconnected with respective leads of the set of leads by way of the metal core connectors.

10. A semiconductor device comprising:
a base leadframe having a plurality of leads and a die pad, a cavity formed in each lead of a set of leads of the plurality of leads;
a first semiconductor die mounted on the die pad of the base leadframe, bond pads of the first semiconductor die interconnected with respective leads of the plurality of leads;
a metal core connector affixed on each cavity of the set of leads;
a packaged device mounted on the base leadframe by way of the metal core connectors, the packaged device including:
a second semiconductor die,
a package leadframe having a plurality of package leads, the second semiconductor die mounted on the package leads of the package leadframe, and
a first encapsulant encapsulating the second semiconductor die and package leadframe, a portion of each of the package leads exposed through the first encapsulant at a bottom major side of the packaged device; and
a second encapsulant encapsulating the first semiconductor die, a portion of the base leadframe, and a portion of the packaged device.

11. The semiconductor device of claim 10, wherein the bond pads of the first semiconductor die are interconnected with the respective leads of the plurality of leads by way of bond wires.

12. The semiconductor device of claim 10 or claim 11, wherein the bottom major side of the packaged device is exposed at a top major side of the semiconductor device.

13. The semiconductor device according to claim 10 to claim 12, wherein the exposed portion of each of the package leads is configured for attachment of an external device.

14. The semiconductor device according to claim 10 to claim 13, wherein the exposed portions of the package leads are interconnected with respective leads of the set of leads by way of the metal core connectors.

15. The semiconductor device according to claim 10 to claim 14, wherein each of the metal core connectors includes a solid copper core surrounded by a solder material.
